# EUROPEAN PATENT SPECIFICATION

(11) **EP 0 544 369 B1**
(45) Date of publication and mention of the grant of the patent: **15.04.1998**
(21) Application number: 92203578.7
(22) Date of filing: 20.11.1992
(51) Int. Cl.: H01L 33/00, H01L 21/324

(54) **Method for processing porous silicon to recover luminescence**
Verfahren zur Behandlung von porösem Silizium zur Zurückgewinnung von Lumineszenz
Méthode pour traiter le silicium poreux pour récupérer la luminescence

(30) Priority: 27.11.1991 US 799596
(43) Date of publication of application: 02.06.1993
(73) Proprietor: Philips Electronics N.V., 5621 BA Eindhoven (NL)
(72) Inventor: Khan, Babar, c/o Int. Octrooibureau B.V., NL-5656 AA Eindhoven (NL); Pinker, Ronald, c/o Int. Octrooibureau B.V., NL-5656 AA Eindhoven (NL); Shahzad, Khalid, c/o Int. Octrooibureau B.V., NL-5656 AA Eindhoven (NL)
(74) Representative: Smeets, Eugenius Theodorus J. M.

(56) References cited:
- APPLIED PHYSICS LETTERS. vol. 59, no. 22 , 25 November 1991 , NEW YORK US pages 2814 - 2816 C. TSAI ET AL. 'Thermal treatment studies of the photoluminescence intensity of porous silicon'
- APPLIED PHYSICS LETTERS. vol. 59, no. 3 , 15 July 1991 , NEW YORK US pages 304 - 306 A. HALIMAOUI ET AL. 'Electroluminescence in the visible range during anodic oxidation of porous silicon films'
- APPLIED PHYSICS LETTERS. vol. 61, no. 8 , 24 August 1992 , NEW YORK US pages 940 - 942 N. OOKUBO ET AL. 'Effects of thermal annealing on porouos silicon photoluminescence dynamics'
- APPLIED PHYSICS LETTERS. vol. 60, no. 14 , 6 April 1992 , NEW YORK US pages 1700 - 1702 C. TSAI ET AL. 'Correlation between silicon hydride species and the photoluminescence intensity of porous silicon'
- JOURNAL OF THE ELECTROCHEMICAL SOCIETY vol. 138, no. 1 , January 1991 , MANCHESTER, NEW HAMPSHIRE US pages 153 - 159 A. VENKATESWARA RAO ET AL. 'In situ Fourier-Transform electromodulated infrared study of the porous silicon formation: evidence for solvent effects on the vibrational linewidths'

## Description

This invention relates to luminescent porous silicon structures and particularly to methodology for processing porous silicon structures to recover luminescence lost in standard manufacturing processes. This methodology permits the manufacture of injection devices from porous silicon structures.

Visible light emission from porous silicon is observed when the silicon in sufficiently porous and the porous silicon is excited by an ultra violet source. It has been found that by increasing the porosity of the silicon by increasing the time of isotropic etching changes the emission towards shorter wavelengths (i.e. towards the blue end of the spectrum). Porous silicon is formed by placing a silicon wafer in a solution of hydrofluoric acid and ethanol and applying a voltage between the silicon and a platinum electrode. This process etches narrow channels into the silicon. The depth of these channels can be controlled by the etching time and current density. The cross section of these channels can be increased (made more porous) by further etching the silicon in an isotropic etch (not an electro-chemical etch). When the silicon is sufficiently porous, the channels almost touch each other and extremely narrow silicon structures (wires) are formed. It is believed that the emission is a quantum wire effect. See the discussion in "Silicon Quantum Wire Array Fabrication by Electrochemical and Chemical Dissolution of Wafers", Applied Physics Letters, Vol. 57, No. 10, 3 September 1990, pp. 1046-1048. The porous silicon can be modeled as narrow pillars of silicon surrounded by air. When the porous silicon wires are sufficiently narrow, it is theorized that the confinement of carriers leads to the formation of effectively a direct gap semiconductor and a shift of energy levels. The narrower the pillars, the more the shift in the energy levels of the bands which is consistent with the shift towards shorter wavelengths with increased etching.

However, it is difficult to process the porous silicon further, without losing its luminescent properties. Accordingly, it is difficult to fabricate active device structures without addressing this problem. For example, porous silicon starts to oxidize at a very low temperature (< 200 °C) and the luminescence starts to decrease. Therefore, any process that oxidizes the porous silicon quenches the luminescence. However, we have found that the luminescence recovers partially when the porous silicon is exposed to a hydrogen plasma. The porous silicon layer is coated with a thin, 70 nm (700 Å) thick layer of silicon dioxide to protect the porous silicon from bombardment in the hydrogen plasma.

The role played by surface states or the passivation of surface states in the process of emission from porous silicon is not known. We have established that loss of passivating hydrogen results in loss of emission intensity and passivation by atomic hydrogen using a hydrogen plasma restores the emission. The recovery of luminescence after hydrogenation suggests that the loss of luminescence is related to the loss of passivating hydrogen from the surface of porous silicon. This loss of hydrogen leads to the formation of surface states, which act as recombination centres and can quench the luminescence. Therefore, not only oxidation, but any processing step that leads to this loss of the hydrogen passivation will quench the luminescence. When the surface is once again passivated by the plasma hydrogenation, the luminescence recovers.

The passivation of silicon/silicon dioxide interfaces or polysilicon/silicon dioxide interfaces by atomic hydrogen, for applications in devices such as thin film transistors (TFTs) or charge coupled devices (CCDs), using a hydrogen plasma is known. However, the usual plasma hydrogenation process for application in TFTs or CCDs is carried out at temperatures exceeding 300°C. In some instances, a protective layer of plasma enhanced silicon dioxide is deposited over the devices to protect them from the ion-bombardment. However, these processes cannot be used with porous silicon. At the high temperatures (> 200 °C), the porous silicon oxidizes easily and the reactivity of the plasma enhanced silicon dioxide deposition process (which uses reactive gases such as silane and nitrous oxide) is too high.

In the present process, prior to the hydrogenation luminance recovery step the silicon is coated with a protective layer preferably of silicon dioxide in order to protect it from ion bombardment. However, many silicon dioxide coating processes are highly reactive and carried out at temperatures which will damage porous silicon. Accordingly, the present process uses sputter deposition of silicon dioxide in an inert (Argon) atmosphere. The sputter deposition is carried out at room temperature. Although sputtering does lead to some ion bombardment, it is clearly less damaging to the porous silicon than is plasma deposition of silicon dioxide.

In the paper by C. Tsai et al in Applied Physics Letters 59 (22), 25th Nov. 1991, p. 2814-2816; it is also demonstrated that surface passivation is necessary for the observation of photoluminescence from porous silicon. However, passivation is accomplished by dipping the porous silicon in hydrofluoric acid.

The present method passivates the porous silicon by using a hydrogen plasma to recover the photoluminescence. Since the hydrogen ions in a plasma process can diffuse right through thin layers of various materials such as silicon dioxide and polysilicon, the present process has important practical implications. Finished devices fabricated with porous silicon can be treated by plasma hydrogenation to recover any luminescent properties lost during the fabrication stage, without detrimental effects on the structure of the device. On the other hand, devices cannot be dipped in hydrofluoric acid to recover the luminescent properties as that will result in damage to the device (for example, any silicon dioxide layers that come into contact with the acid or its fumes will dissolve). Moreover, the porous silicon must be in contact with the hydrofluoric acid in the process of the Tsai paper to passivate the surface, which may not be possible in practical devices in which the porous silicon is buried beneath other thin films.

For better understanding of the invention reference is made to the following drawing figures which are to be taken in conjunction with the detailed specification to follow:
Figure 1 is a graph of luminescent intensity versus wavelength for a sample of porous silicon that has been annealed at various temperatures; and
Figure 2 is a graph of luminescent intensity versus wavelength for a virgin sample of porous silicon (curve 3) a sample that has been oxidized after exposure to air at 325°C (curve 1) and after sputtered oxide deposition and plasma hydrogenation (curve 2).

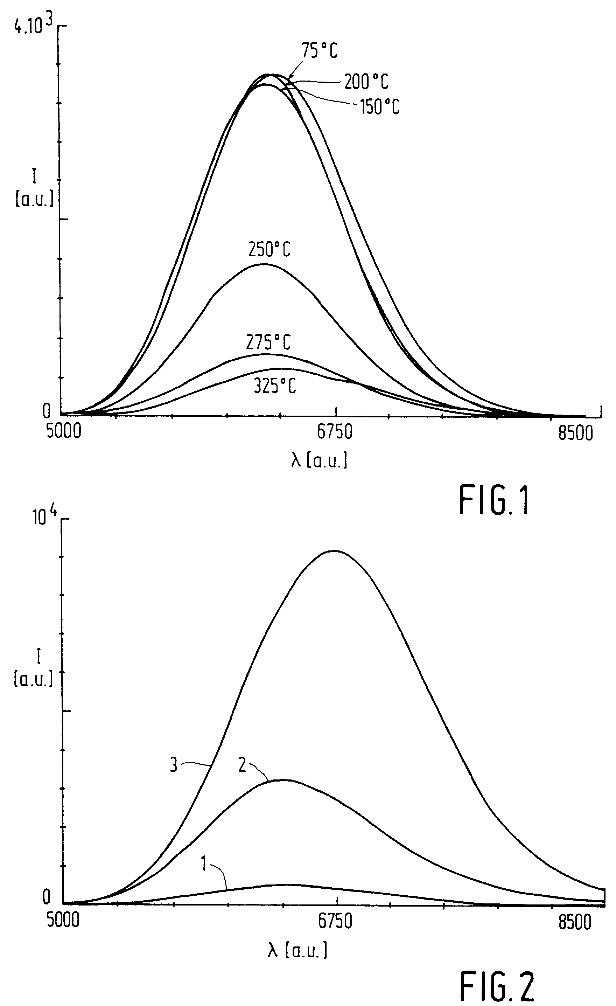

Figure 1 illustrates a curve of luminescent intensity versus wavelength for a sample of porous silicon that has been annealed at various temperature in a "vacuum" system with trace amounts of air. The annealing process is similar to the processing steps that would be undertaken to manufacture an active silicon device. Fig. 1 illustrates that there is very little change in luminescence when the sample is annealed at temperatures of from 75 through 200 °C. However, at an annealing temperature of 250 °C there is a marked decrease in luminescent intensity. At 275 °C and 325 °C the luminescent intensity has decreased by almost an order of magnitude. Accordingly, for most practical purposes the luminescence of this sample of porous silicon has been quenched. The luminescent intensity is lost because of oxidation of the silicon "quantum wires". Oxidation occurs even though the annealing takes place at what would normally be considered a vacuum because the trace amount of oxygen in the "vacuum" atmosphere is sufficient to oxidize the small number of atoms in the porous silicon quantum wires. Accordingly, it is apparent that standard processing of porous silicon into an active device will cause it to lose its luminescent qualities.

The present invention is directed to methodology for recovering luminescence that has been lost due to the processing of the porous silicon wafer. The recovery of lost luminescence permits ready manufacture of electrically pumped porous silicon devices. We have found that lost luminescent intensity may be recovered by the passivation, through hydrogenation, of porous silicon after various processing steps have taken place. Before the plasma hydrogen of the porous silicon, the porous silicon wafer is protected by deposition of SiO₂ in a low temperature process, such as sputtering. The silicon dioxide coating need only be on the order of 70 nm (700 Å) as this is sufficient to prevent ion bombardment of the surface. After the deposition of the SiO₂ the porous silicon is passivated by plasma hydrogenation in a hydrogen atmosphere. The hydrogen passes through the oxide coating to passivate the surface of the quantum wires. As shown in curve 3 of Fig. 2 the luminescence of the hydrogenated porous silicon has partially recovered.

The hydrogenation of the porous silicon wafer may take place in an RF field generated by electrodes or by induction. By way of example only, plasma treatment can be carried out in a Plasma Therm PT700 plasma deposition/etching system in pure hydrogen at 200 W and 300 °C. Alternatively, the hydrogenation can take place in a microwave generated plasma or by electrochemical means. An alternative to the sputtering process for coating the porous silicon with silicon dioxide is electron beam evaporation which can be accomplished at room temperatures, under high vacuum and does not subject the sample to ion bombardment. Another variation can be the substitution of silicon nitride for silicon dioxide. However, the use of silicon nitride will slow the plasma hydrogenation process as the nitride is more of a barrier to hydrogen diffusion than is silicon dioxide.

While optically pumped luminescent devices are of considerable scientific interest a practical device utilizing luminescent porous silicon is likely to arise only from an electrically driven device. An electrically driven luminescent porous silicon device may lead to the long desired integration of optical and electrical devices on a single chip. The heart of most electrically driven devices is a p-n junction (i.e. a diode). The making of an n layer of silicon requires ion implantation and an annealing step, however annealing will destroy the luminescence to a degree that would render the device useless. The above-described methodology provides a way to make an electrically driven porous silicon device. Such methodology for making an electrically driven device will now be described.

An active porous silicon device may be manufactured from a starting wafer of p type silicon. The silicon may be made p type by any of the known process. The p type silicon is thereafter covered with a photoresist and an appropriate aperture is made in the photoresist. Thereafter an n+ layer is implanted through the photoresist. After implantation the photoresist is removed and the wafer is annealed at 1000 °C which will place an n+ well in the p type silicon wafer. At this point the silicon wafer is porosized with an electrochemical etch as is discussed above. The electrochemical etch is followed by a isotropic etch which serves to narrow the columns of silicon. In this regard it is noted that only the p type silicon will etch with the n+ layer remaining unetched. However this is of no consequence since the p type layer which has been porosized will be luminescent.

After the silicon has been porosized a layer of silicon dioxide is sputtered onto the surface. If sputtering is not used another low temperature process should be used in order to not cause extreme loss of luminescence. Thereafter, the device may be patterned with a photoresist and etched in accordance with the desired device to be manufactured. The device may also be covered with an appropriate conducting layer which is patterned in accordance with the device configuration desired. After the various elements of the active device are placed on its surface the whole device is placed in a hydrogen plasma. The hydrogen plasma will pass through the protective oxide layer into the porous silicon to passivate the surface and recover the lost luminescence. The processing steps of this device should, to the extent possible, be low temperature processes so as to minimize loss of luminescence. The luminescence that is lost will be recovered to a certain extent by the hydrogen plasma passivation step.

Another method of fabricating a p-n diode is as follows: An epitaxial layer of lightly doped n-type silicon is grown on a p-type silicon substrate forming a p/n junction. Thereafter n+ regions are selectively implanted in the n layer for contacting. The n layer is then porosized by forward biasing the diode and etching in the usual manner. The n layer becomes porous because holes (which are necessary for the porization process) are supplied by the forward biased junction. The surface is then covered with sputtered silicon dioxide and patterned, a conducting layer (ITO or metal) is then deposited and patterned. The entire structure is then placed in the hydrogen plasma for recovering any luminescence that might have been lost during the processing steps (oxide deposition, photo lithography, metallization, etching, etc.)

Other methods may involve the fabrication of MIS heterostructure based light emitting devices using porous silicon. However, the processes discussed in this application are equally applicable for recovering the light emission properties of porous silicon in those structures. Accordingly, the above-described methodology is merely illustrative of the principles of the present invention.

## Claims

1. A method for recovering luminescence lost from a luminescent porous silicon wafer, characterized in that the method comprises the step of exposing the luminescent porous silicon wafer to a hydrogen plasma and the step of depositing a protective layer of silicondioxide or siliconnitride on the surface of the porous silicon wafer before exposure to the hydrogen plasma, said protective layer permitting hydrogen from the hydrogen plasma to pass to the porous silicon wafer without permitting ion bombardment and said protective layer being applied in a low temperature process.

2. A method as claimed in Claim 1, characterized in that for the protective layer silicondioxide is applied and the protective layer is applied by sputtering.

3. A method for making an active luminescent porous silicon device from silicon, characterized in that the method comprises the steps of providing a wafer of p-type silicon, covering the wafer with a patterned photoresist, implanting n+ wells in the wafer, removing the resist and annealing the wafer, etching the p-type regions of the wafer so as to porosize them, exposing the porous p-type silicon to a hydrogen plasma and depositing a protective layer of silicondioxide or siliconnitride on the surface of the porous p-type silicon before exposure thereof to the hydrogen plasma, said protective layer permitting hydrogen from the hydrogen plasma to pass to the porous p-type silicon without permitting ion bombardment and said protective layer being applied in a low temperature process.

## Patentansprüche

1. Verfahren zur Zurückgewinnung von, aus einer lumineszierenden, porösen Siliciumscheibe verlorengegangener Lumineszenz, dadurch gekennzeichnet, daß nach dem Verfahren die lumineszierende, poröse Siliciumscheibe einem Wasserstoffplasma ausgesetzt und eine Schutzschicht aus Siliciumdioxid oder Siliciumnitrid auf der Oberfläche der porösen Siliciumscheibe aufgebracht wird, bevor diese dem Wasserstoffplasma ausgesetzt wird, wobei durch die Schutzschicht Wasserstoff von dem Wasserstoffplasma zu der porösen Siliciumscheibe geleitet werden kann, ohne dabei einen Ionenbeschuß zuzulassen, und wobei die Schutzschicht in einem Niedertemperaturverfahren aufgebracht wird.

2. Verfahren nach Anspruch 1, dadurch gekennzeichnet, daß für die Schutzschicht Siliciumdioxid verwendet und die Schutzschicht unter Anwendung eines Sputter-Verfahrens aufgebracht wird.

3. Verfahren zur Herstellung einer aktiven, lumineszierenden, porösen Siliciumanordnung aus Silicium, dadurch gekennzeichnet, daß nach dem Verfahren eine Scheibe aus p-leitendem Silicium vorgesehen, die Scheibe mit einem strukturierten Photolack versehen wird, n+ Wannen in die Scheibe implantiert werden, der Photolack entfernt und die Scheibe ausgeheilt wird, die p-leitenden Zonen der Scheibe einer Ätzung unterworfen werden, um diesen Porosität zu verleihen, das poröse, p-leitende Silicium einem Wasserstoffplasma ausgesetzt und eine Schutzschicht aus Siliciumdioxid oder Siliciumnitrid auf der Oberfläche des porösen, p-leitenden Siliciums aufgebracht wird, bevor dieses dem Wasserstoffplasma ausgesetzt wird, wobei durch die Schutzschicht Wasserstoff zu dem porösen, p-leitenden Silicium geleitet wird, ohne dabei einen Ionenbeschuß zuzulassen, und wobei die Schutzschicht in einem Niedertemperaturverfahren aufgebracht wird.

## Revendications

1. Procédé de récupération de la luminescence perdue par une galette de silicium poreux luminescent, caractérisé en ce que le procédé comprend l'étape d'exposition de la galette de silicium poreux luminescent à un plasma d'hydrogène et l'étape de dépôt d'une couche protectrice de dioxyde de silicium ou de nitrure de silicium sur la surface de la galette de silicium poreux avant l'exposition au plasma d'hydrogène, ladite couche protectrice permettant à l'hydrogène du plasma d'hydrogène de passer à la galette de silicium poreux sans permettre un bombardement ionique et ladite couche protectrice étant appliquée dans un procédé à basse température.

2. Procédé suivant la revendication 1, caractérisé en ce que, pour la couche protectrice, du dioxyde de silicium est appliqué et la couche protectrice est appliquée par pulvérisation cathodique.

3. Procédé de fabrication d'un dispositif de silicium poreux luminescent actif à partir de silicium, caractérisé en ce que le procédé comprend les étapes de fourniture d'une galette de silicium du type p, de revêtement de la galette d'une photoréserve comportant des motifs, d'implantation de puits n+ dans la galette, d'élimination de la photoréserve et de recuit de la galette, d'attaque des régions de type p de la galette de façon à les rendre poreuses, d'exposition du silicium de type p poreux à un plasma d'hydrogène et de dépôt d'une couche protectrice de dioxyde de silicium ou de nitrure de silicium sur la surface du silicium de type p poreux avant son exposition au plasma d'hydrogène, ladite couche protectrice permettant à l'hydrogène du plasma d'hydrogène de passer à la galette de silicium de type p poreux sans permettre un bombardement ionique et ladite couche protectrice étant appliquée dans un procédé à basse température.
